**Europäisches Patentamt**

**European Patent Office**

**Office européen des brevets**

(19)

(11) Veröffentlichungsnummer : **0 303 642 B1**

(12) # EUROPÄISCHE PATENTSCHRIFT

(45) Veröffentlichungstag der Patentschrift :
16.10.91 Patentblatt 91/42

(51) Int. Cl.$^5$ : **G01B 9/02, H01S 3/133**

(21) Anmeldenummer : **88901550.9**

(22) Anmeldetag : **12.02.88**

(86) Internationale Anmeldenummer :
**PCT/DE88/00069**

(87) Internationale Veröffentlichungsnummer :
**WO 88/06711 07.09.88 Gazette 88/20**

(54) **LASERINTERFEROMETER ZUR INTERFEROMETRISCHEN LÄNGENMESSUNG.**

(30) Priorität : **27.02.87 DE 3706347**

(43) Veröffentlichungstag der Anmeldung :
**22.02.89 Patentblatt 89/08**

(45) Bekanntmachung des Hinweises auf die
Patenterteilung :
**16.10.91 Patentblatt 91/42**

(84) Benannte Vertragsstaaten :
**AT BE CH DE FR GB IT LI LU NL SE**

(56) Entgegenhaltungen :
**DE-A- 3 404 963**
**DE-B- 1 154 646**
**GB-A- 2 154 787**
**US-A- 4 583 228**
**Feinwerktechnik & Messtechnik, Band 87, nr.**
**8, November/Dezember 1979, (München DE) M**
**Kerner: "Wellenlängenstabilisation", seiten**
**368-372**

(56) Entgegenhaltungen :
**Patent Abstract of Japan, Band 8, nr 88**
**(E-240)(1525) 21 April 1984 & JP A 596585**
**(RICOH KK) 13 Januar 1984**
**Review of Scientific Instruments, Band 52, nr**
**12, December 1981, American Institute of Phy-**
**sics (New York US) WD Drotning: "Laser inter-**
**ferometer for high temperature isothermal**
**length changes over long time periods", Sei-**
**ten 1896-1900**

(73) Patentinhaber :
**FRAUNHOFER-GESELLSCHAFT ZUR**
**FÖRDERUNG DER ANGEWANDTEN**
**FORSCHUNG E.V.**
**Leonrodstrasse 54**
**W-8000 München 19 (DE)**

(72) Erfinder : **HÖFLER, Heinrich**
**Hans-Sachs-Str. 37**
**W-7835 Teningen (DE)**
Erfinder : **BERGMANN, Eckhard**
**Engesserstr. 1a**
**W-7800 Freiburg (DE)**

(74) Vertreter : **Rackette, Karl, Dipl.-Phys. Dr.-Ing**
**Kaiser-Joseph-Strasse 179 Postfach 1310**
**W-7800 Freiburg (DE)**

EP 0 303 642 B1

# Beschreibung

Die Erfindung betrifft ein Laserinterferometer zur interferometrischen Längenmessung mit einem Halbleiterlaser, dessen Licht über einen Strahlteiler ein Meßinterferometer mit zwei Reflektoren, von denen einer mit dem zu erfassenden beweglichen Objekt verbunden ist, und ein zur Regelung der Laserlichtwellenlänge dienendes Referenzinterferometer mit einer fixierten Reflektoranordnung speist, das dem Meßinterferometer räumlich benachbart ist und dessen Interferenzlichtstrahlbündel einen Referenzsignaldetektor speist, der an einen die Frequenz des Halbleiterlasers nachregelnden Regelschaltkreis angeschlossen ist, durch den das Ausgangssignal des Referenzsignaldetektors konstant gehalten wird, während das die Information bezüglich der zu erfassenden Länge enthaltende Interferenzlichtstrahlbündel des Meßinterferometers einen Interferenzsignaldetektor beaufschlagt, dessen Ausgangssignal eine Auswertevorrichtung zur Bestimmung von Abstandsveränderungen des beweglichen Objektes speist.

Laserinterferometer werden in der Längenmeßtechnik eingesetzt, um geometrischen Größen, wie Längen, Wege, Geschwindigkeiten usw. zu erfassen. Insbesondere erfolgt ihr Einsatz bei Werkzeugmaschinen und Koordinatenmeßmaschinen. Um hohe Meßgenauigkeiten zu erhalten, ist es erforderlich, den Einfluß des Brechungsindexes der Umgebungsluft auf den als Wellenlängennormal eingesetzten Laserstrahl zu berücksichtigen. Eine solche Berücksichtigung des Brechzahleinflusses infolge einer Veränderung der Lufttemperatur, des Luftdruckes und der Luftfeuchte geschieht häufig nach einem sogenannten Parameterverfahren, bei dem aus Einzelmessungen der Lufttemperatur, des Luftdruckes und der Luftfeuchte die Brechzahl ermittelt wird, um mit Hilfe des so erhaltenen Ergebnisses die Längenmessung zu korrigieren. Hierdurch ergeben sich nicht nur zeitliche Verzögerungen bis das korrekte Meßergebnis vorliegt, sondern auch Probleme, wenn die Brechzahleinflüsse schnellen Änderungen unterliegen, weil dann eine Berücksichtigung nicht möglich ist.

Ein Laserinterferometer zur Längenmessung mit einem Meßinterferometer und einem zur Regelung der Laserlichtwellenlänge dienenden Referenzinterferometer ist aus der DE 34 04 963 A1 bekannt. Das Referenzinterferometer dient zur Stabilisierung der Frequenz bzw. der Wellenlänge des verwendeten Halbleiterlasers und ist zusammen mit den optischen Komponenten des Meßinterferometers auf einer Grundplatte fixiert, um einen kompakten, nur wenig Raum beanspruchenden Aufbau zu erhalten. Der zur Stabilisierung der Laserlichtwellenlänge dienende Arm des Referenzinterferometers erstreckt sich parallel zur der Kompaktheit wegen kleinen Grundplatte quer zur Ausbreitungsrichtung des Lichtes im Meßarm des Meßinterferometers. Da das Licht im Referenzinterferometer auf seinem Weg zum seitlich gegenüber dem Meßarm versetzten Referenzstreckenreflektor eine kurze Luftstrecke durchquert, erfolgt bei der Laserlichtwellenlängenstabilisierung eine Kompensation entsprechend den durch die Temperatur, den Druck und die Feuchtigkeit der Luft oberhalb der Grundplatte beeinflußten Brechungsindex.

Aus Feinwerktechnik & Meßtechnik, Band 87, Nr. 8, November/Dezember 1979 (München, DE), M. Kerner: "Wellenlängenstabilisation", Seiten 368-372 sind Verfahren zur Stabilisierung der Wellenlänge bekannt, um für interferometrische Längenmessungen in freier Atmosphäre die Wellenlänge eines He-Ne-Lasers in Abhängigkeit vom Brechungsindex der Luft konstant zu halten. Dabei wird mit einem hochauflösenden Spektralapparat der Brechungsindex der Luft gemessen und über einen Regelkreis die Frequenz des Lasers so gesteuert, daß dessen Wellenlänge konstant bleibt. Als hochauflösender Spektralapparat ist dabei insbesondere ein Fabry-Perot-Interferometer als besonders geeignet beschrieben. Der bei der bekannten Vorrichtung verwendete He-Ne-Laser verfügt über einen Innenspiegel, wobei seine Resonatorlänge durch einen piezokeramischen Ring verändert werden kann. Dabei ist jedoch der zur Verfügung stehende Regelbereich sehr gering, so daß nur kleinste Korrekturen möglich sind und ein Einsatz nur in bereits klimatisierten Räumen sinnvoll ist.

In der GB, A, 2154787 ist eine Anordnung zum Stabilisieren der Wellenlänge eines Halbleiterlasers beschrieben, die ein faseroptisches Fabry-Perot-Interferometer verwendet. Ein Fehlersignal wird der Laserstromversorgung in der Weise zugeführt, daß der Laserstrom immer in einer Weise verändert wird, die zu einem Verändern in Richtung auf die gewünschte Frequenz führt. Auf diese Weise steht für ein zweites faseroptisches Interferometer immer Licht mit einer stabilisierten Wellenlänge zur Verfügung.

Aus dem Patent Abstracts of Japan, Band 8, Nr. 88 (E-240) (1525), 21. April 1984 und JP, A, 596585 sind ein Verfahren zum Stabilisieren der Wellenlänge eines Halbleiterlasers bekannt. Dabei werden zwei Regelkreise verwendet, wobei der erste ein Peltierelement enthält und der zweite Regelkreis vorgesehen ist, um die Wellenlänge des Lasers konstant zu halten. Eine Kompensation eines Brechzahleinflusses ist nicht vorgesehen.

In Review of Scientific Instruments, Band 52, Nr. 12, Dezember 1981, American Institute of Physics, (New York, US), W.D. Drotning: "Laser interferometer for high temperature isothermal length changes over long time periods", Seiten 1896-1900 ist ein Laserinterferometer mit einem He-Ne-Laser beschrieben, um präzise Längenänderungsmessungen über längere Zeiten durchzuführen. Da die Messung nicht durch Verändern der Laserfrequenz erfolgt, ist es nicht notwendig, die Laserlichtwellenlänge in Luft zu steuern oder zu stabilisieren.

Aus der US, A, 4583228 ist eine Anordnung mit einem Halbleiterlaser bekannt, der unter Verwendung eines Fabry-Perot-Interferometers stabilisiert wird. Brechzahleinflüsse in der Umgebungsluft werden nicht berücksichtigt.

Die DE, B, 1154646 beschreibt eine Vorrichtung zur kontinuierlichen Längenmessung mittels Interferenzen in einem über die Kohärenzlänge hinausgehenden Meßbereich. Die bekannte Vorrichtung verfügt jedoch über keinen Laser und enthält auch keinen Regelkreis zum Stabilisieren der Wellenlänge der Lichtquelle.

Der Erfindung liegt die Aufgabe zugrunde, ein Laserinterferometer der eingangs genannten Art zu schaffen, das sich auch dann durch eine hohe Meßgenauigkeit auszeichnet, wenn die Meßstrecke im Meßarm des Laserinterferometers durch lokale Turbulenzen und Inhomogenitäten innerhalb der Meßstrecke gestört wird.

Diese Aufgabe wird erfindungsgemäß dadurch gelöst, daß in einem Laserinterferometer der eingangs genannten Art die Referenzstrecke des Referenzinterferometers sich in einem im Verhältnis zur Länge der Referenzstrecke kleinen seitlichen Abstand parallel zur Meßstrecke des Meßinterferometers erstreckt, daß die Referenzstrecke und die Meßstrecke vergleichbare Längen aufweisen und so ausgebildet sind, daß das Referenzinterferometer und das Meßinterferometer im wesentlichen vom gleichen Luftvolumen beeinflußt werden, und daß die Referenzstrecke an ihrem vom Halbleiterlaser wegweisenden Ende durch einen Referenzstreckenreflektor begrenzt ist, dessen während einer Messung fixierte Position in Längsrichtung der Meß- und Referenzstrecke justierbar ist.

Mit Hilfe des sich entlang dem Meßinterferometer erstreckenden Referenzinterferometers und des damit verbundenen Regelschaltkreises wird der Speisestrom und die Betriebstemperatur des Halbleiterlasers bei Veränderungen der Brechzahl der Luft im Meßarm des Laserinterferometers jeweils so geändert, daß das Verhältnis der Vakuumlänge zur Brechzahl der Luft, d.h. die Luftwellenlänge, konstant bleibt. Auf diese Weise wird erreicht, daß das Wellenlängennormal für das vom Meßstrahl tatsächlich durchquerte Luftvolumen eine konstante Länge aufweist, da sowohl das Referenzinterferometer als auch das Meßinterferometer im wesentlichen vom gleichen Luftvolumen beeinflußt werden.

Zweckmäßige Weiterbildungen und Ausgestaltungen der Erfindung sind in den abhängigen Ansprüchen gekennzeichnet.

Nachfolgend wird die Erfindung anhand eines in der Zeichnung dargestellten Ausführungsbeispiels näher erörtert. Es zeigen:

Fig. 1 eine schematische Darstellung des Meßinterferometers und des damit gekoppelten Referenzinterferometers gemäß der Erfindung und

Fig. 2 einen Regelschaltkreis zur Steuerung des Halbleiterlasers in Abhängigkeit von dem Ausgangssignal des Referenzinterferometers.

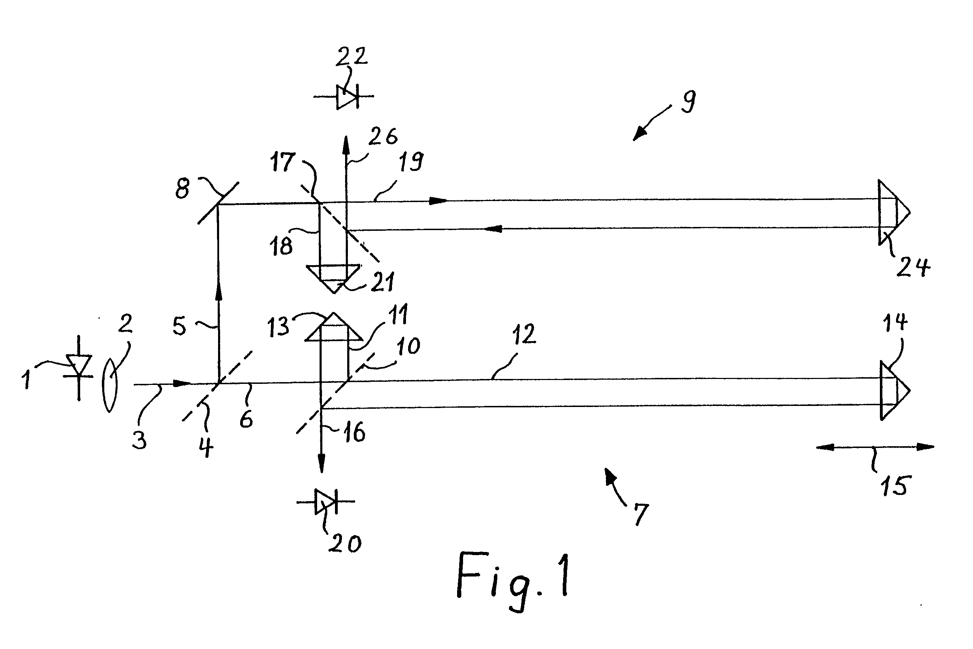

Das in Fig. 1 dargestellte Laserinterferometer zur interferometrischen Messung geometrischer Größen verfügt über einen Halbleiterlaser 1, der in Fig. 1 schematisch mit der ihm zugeordneten Optik 2 dargestellt ist. Das die Optik 2 verlassende Laserstrahllichtbündel 3 wird mit Hilfe eines Hauptstrahlteilers 4 in ein Referenzlichtstrahlbündel 5 und ein Meßlichtstrahlbündel 6 aufgeteilt.

Das Meßlichtstrahlbündel 6 dient zum Betrieb eines in Fig. 1 schematisch dargestellten Meßinterferometers 7, das als Michelson-Interferometer aufgebaut ist. Das Referenzlichtstrahlbündel 5 speist über einen Umlenkspiegel 8 ein zweites Michelson-Interferometer, das als Referenzinterferometer 9 dient.

Das das Meßinterferometer 7 speisende Meßlichtstrahlbündel 6 wird mit Hilfe eines Meßstreckenstrahlteilers 10 in ein erstes Lichtstrahlbündel 11 und ein zweites Lichtstrahlbündel 12 aufgeteilt. Das erste Lichtstrahlbündel 11 gelangt zu einem Meßreflektor 13, der ein Tripelreflektor ist und das erste Lichtstrahlbündel 11 zu einem Meßsignaldetektor 20 umlenkt.

Das zweite Lichtstrahlbündel 12 breitet sich entlang der Meßstrecke aus und gelangt schließlich zu einem in Ausbreitungsrichtung des Lichtstrahlbündels 12 beweglichen Meßstreckenreflektor 14, der ebenfalls ein Trippelreflektor ist und z.B. der Bewegung des zu vermessenden Gegenstandes oder der Kontur eines zu vermessenden Gegenstandes folgt. Die Länge der Meßstrecke kann beispielsweise in der Größenordnung von 1 m liegen. Die Bewegung des mobilen Meßstreckenreflektors 14 in Richtung des Doppelpfeils 15 kann beispielsweise ebenfalls in der Größenordnung von 1 m liegen.

Das vom Meßstreckenreflektor 14 seitlich versetzt zurückreflektierte zweite Lichtstrahlbündel 12 durchläuft erneut die Meßstrecke und gelangt schließlich auf die Rückseite des Meßstreckenstrahlteilers 10, durch den das zweite Lichtstrahlbündel 12 in Richtung auf den Meßsignaldetektor 20 umgelenkt wird, wobei das zweite Lichtstrahlbündel 12 mit dem ersten Lichtstrahlbündel 11 ein Interferenzlichtstrahlbündel 16 bildet.

Bei einer Verschiebung des mobilen Meßstreckenreflektors 14 entsprechend der Bewegung des zu überwachenden Objektes oder dem Verlauf der zu erfassenden Kontur verändert sich die vom zweiten Lichtstrahlbündel 12 zu durchlaufende Strecke und damit die Umlaufphase des Meßinterferometers 7, so daß am Meßsignaldetektor 20 eine Folge von Signalmaxima und Signalminima in Abhängigkeit von der Lichtwellenlänge, dem Brechungsindex des Mediums in der Meßstrecke und in der Verschiebung des Meßstreckenreflektors 14 auftritt.

Infolge der Abhängigkeit des Interferenzsignals am Meßsignaldetektor 20 vom Brechungsindex des vom zweiten Lichtstrahlbündel 12 durchquerten Mediums können sich Meßfehler ergeben, wenn die durch eine Veränderung der Brechzahl ergebende Veränderung der als Wellenlängennormal wirksamen Wellenlänge nicht kompensiert wird.

Bei dem in Fig. 1 schematisch dargestellten Interferometer erfolgt eine Kompensation des Brechzahleinflusses mit Hilfe des bereits erwähnten Referenzinterferometers 9, durch das Brechzahländerungen erfaßt werden, um entsprechend der Änderungen die Frequenz, bzw. die Vakuumwellenlänge des Halbleiterlasers so nachzuregeln, daß die im Meßinterferometer 7 verwendete Wellenlänge in Luft des zweiten Lichtstrahlbündels 12 konstant bleibt.

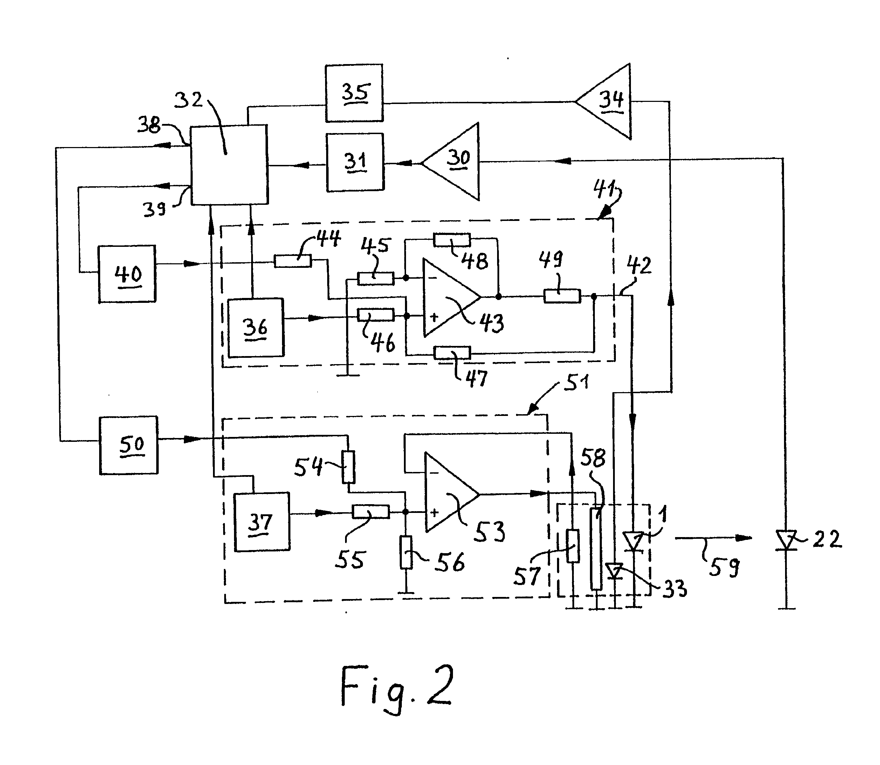

Nach dem Umlenken mit Hilfe des Umlenkspiegels 8 gelangt das Referenzlichtstrahlbündel 5 zum Referenzinterferometer 9, das entsprechend dem Meßinterferometer 7 über einen Referenzstreckenstrahlteiler 17 verfügt. Das vom Referenzstreckenstrahlteiler 17 abgelenkte erste Referenzlichtstrahlbündel 18 wirft mit Hilfe eines Referenzreflektors 21 umgelenkt und gelangt nach einem Durchqueren des Referenzstreckenstrahlteilers 17 zu einem Referenzsignaldetektor 22, der ebenso wie der Halbleiterlaser 1 mit der in Fig. 2 dargestellten Schaltungsanordnung verbunden ist, während die dem Meßsignaldetektor 20 zugeordnete Schaltungsanordnung zur Auswertung der Meßstrecke in der Zeichnung nicht dargestellt ist.

Auf der dem Spiegel 8 gegenüberliegenden Seite des Referenzstrahlteilers 17 breitet sich ein zweites Referenzlichtstrahlbündel 19 entlang einer Referenzstrecke mit einer Länge von beispielsweise 1 m aus und gelangt auf einen immobilen Referenzstreckenreflektor 24, der im Gegensatz zum Meßstreckenreflektor 14 an einer fixierten Stelle angeordnet ist, wobei jedoch eine Justierung der Länge der Referenzstrecke zur Anpassung an die Länge der Meßstrecke vorgesehen sein kann.

Der seitliche Abstand zwischen der Meßstrecke des Meßinterferometers 7 und der Referenzstrecke des Referenzinterferometers 9 ist möglichst klein und beträgt beispielsweise lediglich einige Zentimeter, um zu erreichen, daß Veränderungen in der Temperatur, dem Luftdruck, der Luftfeuchte und der Zusammensetzung der Luft im Meßinterferometer 7 möglichst auch vom Referenzinterferometer 9 erfaßt werden. Aus diesem Grunde liegen das zweite Lichtstrahlbündel 12 und das zweite Referenzlichtstrahlbündel 19 nicht nur so nahe wie möglich beieinander, sondern die Referenzstrecke und die Meßstrecke erstrecken sich auch über vergleichbare Längen um sicherzustellen, daß möglichst alle lokalisierten Störungen in der Meßstrecke von der Referenzstrecke erfaßt werden.

Das vom Referenzstreckenreflektor 24 parallel zur Einfallsrichtung seitlich versetzt zurückreflektierte zweite Referenzlichtstrahlbündel 19 wird mit Hilfe des Referenzstreckenstrahlteilers 17 so in den Referenzsignaldetektor 22 umgelenkt, daß ein Interferenzlichtstrahlbündel 26 gebildet wird. Je nach der Umlaufphase befindet sich das den Referenzsignaldetektor 22 beaufschlagende Signal in einem Minimum, einem Maximum oder auf einer Flanke.

Der in Fig. 2 dargestellte Regelschaltkreis dient dazu, trotz Änderungen der Brechzahl in der Referenzstrecke das Interferenzsignal am Referenzsignaldetektor 22 konstant zu halten. Dies geschieht durch eine elektronische Regelung des Stroms und der Temperatur des Halbleiterlasers 1, wobei die Vakuumwellenlänge oder Frequenz des Halbleiterlasers 1 derart verändert wird, daß das Verhältnis der Vakuumwellenlänge im Referenzstreckenmedium zur Brechzahl im Referenzstreckenmedium, d.h. die tatsächliche Wellenlänge im Medium der Referenzstrecke, konstant gehalten wird.

Der Referenzsignaldetektor 22 speist, wie man in Fig. 2 erkennen kann, über einen Verstärker 30 und einen Analog/Digitalwandler 31 einen der Eingänge eines Mikroprozessors 32, in dem ein Regelungs- und Stabilisierungsprogramm gespeichert ist, um die Vakuumwellenlänge des Halbleiterlasers 1 bzw. dessen Frequenz so zu verändern, daß die als Meßnormal dienende tatsächliche Wellenlänge im Medium der Referenzstrecke und damit der Meßstrecke unabhängig von Brechzahleinflüssen konstant bleibt.

Dem Mikroprozessor 32 wird weiterhin das Signal einer vom Halbleiterlaser 1 ebenfalls bestrahlten Fotodiode 33 zugeführt, die als Überwachungsdiode verwendet wird und deren Ausgangssignal über einen Verstärker 34 und eine Schwellenwertschaltung 35 dem Mikroprozessor 32 zugeführt wird, um zu erreichen, daß der Speisestrom und die Temperatur des Halbleiterlasers 1 innerhalb der vorgesehenen Bereiche bleiben.

Die von der Fotodiode 33 bewirkte Schutzfunktion bewirkt beispielsweise, daß eine Begrenzung -für die Strom- und Temperaturregelung über den Mikroprozessor 32 erfolgt, wenn die Maximalleistung des Halbleiterlasers 1 erreicht ist.

Ein Stromsollwertgeber 36 und ein Temperatursollwertgeber 37 sind ebenfalls mit Eingängen des Mikroprozessors 32 verbunden, der über einen Stromsteuerausgang 39 und einen Temperatursteuerausgang 38 den Speisestrom und die Temperatur des Halbleiterlasers 1 steuert.

Der Stromsteuerausgang 39 ist über einen Digital/Analogwandler 40 mit dem Eingang eines Stromreglers 41 verbunden, an dessen Ausgangsleitung 42 der Halbleiterlaser 1 angeschlossen ist. Der Stromregler 41 enthält einen Operationsverstärker 43, der mit Widerständen 44 bis 49 derart geschaltet ist, daß eine Summierung der vom Digital/Analogwandler 40 und vom Stromsollwertgeber 36 gelieferten Signale erfolgt.

Der Temperatursteuerausgang 38 des Mikroprozessors 32 ist mit einem Digital/Analogwandler 50 verbunden, dessen Ausgang einen Temperaturregler 51 speist. Der Temperaturregler 51 enthält neben dem Temperatursollwertgeber 37 einen Operationsverstärker 53 sowie Widerstände 54, 55, 56, die jeweils mit einem Anschluß am nichtinvertierenden Eingang des Operationsverstärkers 53 liegen. Der invertierende Eingang des Operationsverstärkers 53 ist mit einem Temperatursensor 57 verbunden, der thermisch mit dem Halbleiterlaser 1 gekoppelt ist.

Der Ausgang des Operationsverstärkers 53 ist an einen Peltierkühler 58 angeschlossen, der ebenfalls thermisch mit dem Halbleiterlaser 1 gekoppelt ist. Während sich mit Hilfe des Peltierkühlers 58 eine verhältnismäßig träge Grobjustierung für die Vakuumwellenlänge bzw. Frequenz des Halbleiterlasers 1 erreichen läßt, gestattet die Stromspeisung über die Ausgangsleitung 42 eine schnelle und trägheitslose Feinjustierung, um zeitlich schnell veränderliche Brechzahleinflüsse in der Meßstrecke und Referenzstrecke, die in Fig. 2 durch den Pfeil 59 veranschaulicht ist, zu kompensieren.

## Patentansprüche

1. Laserinterferometer zur interferometrischen Längenmessung mit einem Halbleiterlaser (1), dessen Licht (3) über einen Strahlteiler (4) ein Meßinterferometer (7) mit zwei Reflektoren (13, 14), von denen einer mit einem zu erfassenden beweglichen Objekt verbunden ist, und ein zur Regelung der Laserlichtwellenlänge dienendes Referenzinterferometer (9) mit einer fixierten Reflektoranordnung (21, 24) speist, das dem Meßinterferometer (7) räumlich benachbart ist und dessen Interferenzlichtstrahlbündel (26) einen Referenzsignaldetektor (22) speist, der an einen die Frequenz des Halbleiterlasers (1) nachregelnden Regelschaltkreis (30 - 58) angeschlossen ist, durch den das Ausgangssignal des Referenzsignaldetektors (22) konstant gehalten wird, während das die Information bezüglich der zu erfassenden Länge enthaltende Interferenzlichtstrahlbündel (16) des Meßinterferometers (7) einen Interferenzsignaldetektor (20) beaufschlagt, dessen Ausgangssignal eine Auswertevorrichtung zur Bestimmung von Abstandsveränderungen des beweglichen Objektes speist, **dadurch gekennzeichnet**, daß die Referenzstrecke (19) des Referenzinterferometers (9) sich in einem im Verhältnis zur Länge der Referenzstrecke (19) kleinen seitlichen Abstand parallel zur Meßstrecke (12) des Meßinterferometers (7) erstreckt, daß die Referenzstrecke (19) und die Meßstrecke (12) vergleichbare Längen aufweisen und so ausgebildet sind, daß das Referenzinterferometer (9) und das Meßinterferometer (7) im wesentlichen vom gleichen Luftvolumen beeinflußt werden, und daß die Referenzstrecke (19) an ihrem vom Halbleiterlaser (1) wegweisenden Ende durch einen Referenzstreckenreflektor (24) begrenzt ist, dessen während einer Messung fixierte Position in Längsrichtung der Meß- und Referenzstrecke (12, 19) justierbar ist.

2. Laserinterferometer nach Anspruch 1, **dadurch gekennzeichnet**, daß der Regelschaltkreis (30 bis 58) an einen thermisch mit dem Halbleiterlaser (1) gekoppelten Peltierkühler (58) angeschlossen ist.

3. Laserinterferometer nach Anspruch 2, **dadurch gekennzeichnet**, daß der Regelschaltkreis (30 bis 58) über einen thermisch mit dem Halbleiterlaser (1) gekoppelten Temperatursensor (57) verfügt.

4. Laserinterferometer nach einem der Ansprüche 1 bis 3, **dadurch gekennzeichnet**, daß der Regelschaltkreis (30 bis 58) einen Mikroprozessor (32) aufweist, durch den der vom Referenzsignaldetektor (22) zugeführte Istwert mit den Sollwerten des Speisestromes und der Betriebstemperatur des Halbleiterlasers (1) verknüpft werden.

5. Laserinterferometer nach Anspruch 4, **dadurch gekennzeichnet**, daß der Regelschaltkreis (30 bis 58) eine mit dem Licht des Halbleiterlasers (1) beaufschlagte lichtempfindliche Überwachungsdiode (33) in einer Schaltungsanordnung aufweist, die der Begrenzung des Speisestromes und der Betriebstemperatur des Halbleiterlasers (1) dient.

6. Laserinterferometer nach einem der vorstehenden Ansprüche, **dadurch gekennzeichnet**, daß das konstant gehaltene Ausgangssignal des Referenzsignaldetektors (22) einem Maximum, einem Minimum oder einer Flanke des Interferenzsignales zugeordnet ist.

7. Laserinterferometer nach einem der vorstehenden Ansprüche, **dadurch gekennzeichnet**, daß die Referenzstrecke des Referenzinterferometers (9) parallel zur Meßstrecke des Meßinterferometers (7) im seitlichen Abstand von einigen Zentimetern verläuft.

## Claims

1. A laser interferometer for the interferometric measurement of length comprising a semiconductor laser (1) whose light (3), by way of a beam splitter (4), feeds a measuring interferometer (7) with two reflectors (13, 14) of which one is connected to a movable object to be detected, and a reference interferometer (9) with a fixed reflector arrangement (21, 24), which reference interferometer serves to regulate the laser light wavelength and is spatially adjacent the measuring interferometer and rose interference light beam (26) feeds a reference signal detector (22) connected to a regulating circuit (30-58) rich adjusts the frequency of the semiconductor laser (1) and by means of which the output signal of the reference signal detector (22) is kept constant while the interference light beam (16) of the measuring interferometer (7), rich contains the information in respect of the length to be detected, acts on an interference signal detector (20) rose output signal feeds an evaluation means for determining variations in distance of the movable object, characterised in that the reference section (19) of the reference interferometer (9) extends parallel to the measuring section (12) of the measuring interferometer (7) at a lateral spacing rich is small in relation to the length of the reference section (19), that the reference section (19) and the measuring section (12) are of comparable lengths and are such that the reference interferometer (9) and the measuring interferometer (7) are influenced substantially by the same air volume and that the reference section (19) is delimited at its end facing away from the semiconductor laser (1) by a reference section reflector (24) rose position which is fixed during a measuring operation is adjustable in the longitudinal direction of the measuring and reference sections (12, 19).

2. A laser interferometer according to claim 1 characterised in that the regulating circuit (30 to 58) is connected to a Peltier cooler (58) thermally coupled to the semiconductor laser (1).

3. A laser interferometer according to claim 2 characterised in that the regulating circuit (30 to 58) has a temperature sensor (57) thermally coupled to the semiconductor laser (1).

4. A laser interferometer according to one of claims 1 to 3 characterised in that the regulating circuit (30 to 58) has a microprocessor (32) for linking the actual value supplied by the reference signal detector (22) to the reference values of the feed current and the operating temperature of the semiconductor laser (1).

5. A laser interferometer according to claim 4 characterised in that the regulating circuit (30 to 58) has a photosensitive monitoring diode (33) receiving the light of the semiconductor laser (1), in a circuit arrangement rich serves to limit the feed current and the operating temperature of the semiconductor laser (1).

6. A laser interferometer according to one of the preceding claims characterised in that the output signal of the reference signal detector (22), which is kept constant, is associated with a maximum, a minimum or an edge of the interference signal.

7. A laser interferometer according to one of the preceding claims characterised in that the reference section of the reference interferometer (9) extends parallel to the measuring section of the measuring interferometer (7) at a lateral spacing of a few centimetres.

**Revendications**

1. Interféromètre laser destiné à une mesure de longueurs par interférométrie comprenant un laser semi-conducteur (1), dont la lumière (3) est amenée, par une lame séparatrice (4), à un interféromètre de mesure (7) comportant deux réflecteurs (13, 14), dont l'un est relié à un objet mobile à détecter, et à un interféromètre de référence (9) servant au réglage de la longueur d'onde de la lumière laser comportant un agencement fixe de réflecteurs (21, 24) qui est voisin dans l'espace de l'interféromètre de mesure (7) et dont le faisceau lumineux d'interférence (26) est amené à un détecteur (22) de signal de référence qui est raccordé à un circuit de réglage (30 à 58), qui rajuste la fréquence du laser semi-conducteur (1) et au moyen duquel le signal d'émission du détecteur de signal de référence (22) est maintenu constant, tandis que le faisceau lumineux d'interférence (16) contenant l'information concernant la longueur à détecter est appliqué à un détecteur (20) de signal d'interférence dont le signal d'émission est amené à un dispositif d'évaluation pour déterminer des variations de distance de l'objet mobile, caractérisé en ce que l'intervalle de référence (19) de l'interféromètre de référence (9) est situé parallèlement à l'intervalle de mesure (12) de l'interféromètre de mesure (7), à une distance latérale faible par rapport à la longueur de l'intervalle de référence (19), en ce que l'intervalle de référence (19) et l'intervalle de mesure (12) présentent des longueurs comparables et sont réalisés de telle manière que l'interféromètre de référence (9) et l'interféromètre de mesure (7) sont sensiblement influencés par le même volume d'air et en ce que l'intervalle de référence (19) est limité. à son extrémité opposée au laser semi-conducteur (1), par un réflecteur (24) d'intervalle de référence dont la position, fixe pendant une mesure, est réglable dans la direction longitudinale de l'intervalle de mesure et de référence (12, 19).

2. Interféromètre laser selon la revendication 1, caractérisé en ce que le circuit de réglage (30 à 58) est raccordé à un élément frigorifique de Peltier (58) accouplé thermiquement au laser semi-conducteur (1).

3. Interféromètre laser selon la revendication 2, caractérisé en ce que le circuit de réglage (30 à 58) comporte un capteur de température (57) accouplé thermiquement au laser semi-conducteur (1).

4. Interféromètre laser selon l'une des revendications 1 à 3, caractérisé en ce que le circuit de réglage (30 à 58) comporte un microprocesseur (32) au moyen duquel la valeur réelle amenée à partir du détecteur (22) de signal de référence est reliée aux valeurs de consigne du courant d'alimentation et de la température de fonctionnement du laser semi-conducteur (1).

5. Interféromètre laser selon la revendication 4, caractérisé en ce que le circuit de réglage (30 à 58) comprend, dans un agencement de circuit servant à limiter le courant d'amenée et la température de fonctionnement du laser semi-conducteur (1), une diode de surveillance (32), sensible à la lumière, à laquelle est appliquée la lumière du laser semi-conducteur (1).

6. Interféromètre laser selon l'une des revendications précédentes, caractérisé en ce que le signal d'émission maintenu constant du détecteur (22) de signal de référence est associé à un maximum, à un minimum ou un flanc du signal d'interférence.

7. Interféromètre laser selon l'une des revendications précédentes, caractérisé en ce que l'intervalle de référence de l'interféromètre de référence (9) est parallèle à l'intervalle de mesure de l'interféromètre de mesure (7) et situé à une distance latérale de quelques centimètres.

Fig.1

EP 0 303 642 B1

Fig. 2

EP 0 303 642 B1